# EUROPEAN PATENT APPLICATION

(11) **EP 4 772 900 A1**
(43) Date of publication of application: **08.07.2026**
(21) Application number: 25869579.0
(22) Date of filing: 24.06.2025
(51) Int. Cl.: G01R 31/396, G01R 31/3835, G01R 31/392, G01R 31/367, G01R 31/36, G01R 19/165, B60L 58/10

(54) **DEVICE FOR ESTIMATING BATTERY MANUFACTURER AND OPERATING METHOD THEREOF**

(30) Priority: 27.09.2024 KR 20240131951
(71) Applicant: LG Energy Solution, Ltd., Seoul 07335 (KR)
(72) Inventor: MOON, Chi Ho, Daejeon 34122 (KR)
(74) Representative: Goddar, Heinz J.
(86) International application number: PCT/KR2025/008761
(87) International publication number: WO 2026/071396

(57) **Abstract**

A device according to an embodiment disclosed in this document may include an interface configured to acquire target voltage data for a battery; and one or more processors configured to output battery manufacturer estimation information corresponding to the battery based on at least a portion of the target voltage data.

## Description

### TECHNICAL FIELD

### Cross-reference to Related Applications

This application claims priority from Korean Patent Application No. 10-2024-0131951, filed on September 27, 2024, the disclosure of which is incorporated by reference herein.

### Technical Field

Embodiments disclosed in this document relate to a device for estimating a battery manufacturer and a method of operating the same.

### BACKGROUND ART

Research and development on secondary batteries is being have been actively conducted recently. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. In addition, the scope of use of the lithium ion batteries has expanded to include a power source for electric vehicles, and the lithium ion batteries are attracting attention as a next-generation energy storage medium.

In addition, the secondary battery may generally be used as a battery pack including a battery module in which a plurality of battery cells are connected in series and/or in parallel. In addition, the secondary battery may be used as a battery rack including a plurality of battery modules and a rack frame that accommodates the battery modules.

Such battery cells, battery modules, battery packs, or battery racks may be utilized in various devices. For example, the battery may be utilized in mobile devices such as mobile phones, laptop computers, smart phones, and smart pads, as well as in electric vehicles (EVs, HEVs,and PHEVs), large-capacity power storage devices (ESS), etc.

The state and operation of these batteries may be managed and controlled by a battery management system (BMS). The battery management system may be included together with the battery in a single device.

In addition, the battery management system may manage and control the battery while being separated from the device including the battery. For example, the battery management system may be implemented as a separate server device. In this case, the battery management system may collect battery data and vehicle data from vehicles, etc., and utilize the collected data to manage and control the battery.

### DISCLOSURE OF THE INVENTION

### TECHNICAL PROBLEM

In order to smoothly use products that utilize batteries, such as automobiles, an accurate diagnosis of a state of health (SOH) of the battery is required, and the SOH may be calculated based on an open circuit voltage (OCV) table.

As an example, the manufacturers of batteries mounted on the same type of vehicle may be different, and even if the design capacities of the batteries mounted on the corresponding type of vehicle are the same, the chemical composition of the batteries may be different for each battery manufacturer. Therefore, in order to accurately calculate the SOH of a specific battery mounted on a specific automobile among the automobiles of the corresponding vehicle type, OCV table information corresponding to the specific battery is required, and for this, battery manufacturer information for the specific battery is required.

However, since information on which battery among the batteries that can be mounted on the corresponding type of vehicle is actually mounted on the specific automobile of the corresponding type of vehicle is not provided, the SOH has been calculated based on approximate OCV table information in the past, and thus there is a problem in that it is difficult to calculate an accurate SOH.

Embodiments disclosed in this document may provide a device capable of estimating a battery manufacturer based on voltage data of the battery and a method of operating the same.

The technical problems of this document are not limited to the technical problems mentioned above, and other technical problems that are not mentioned may be clearly understood by those skilled in the art from the descriptions below.

### TECHNICAL SOLUTION

A device according to an embodiment disclosed in this document includes an interface configured to acquire target voltage data for a battery; and one or more processors configured to output battery manufacturer estimation information corresponding to the battery based on at least a portion of the target voltage data.

In the device according to an embodiment disclosed in this document, the one or more processors may be configured to output the battery manufacturer estimation information based on a result of comparing at least a portion of the target voltage data with at least a portion of first reference voltage data to m-th reference voltage data that respectively corresponding to a first battery manufacturer to an m-th battery manufacturer.

In the device according to an embodiment disclosed in this document, the one or more processors may be configured to output the battery manufacturer estimation information based on a result of comparing at least a portion of specific first reference voltage data to specific m-th reference voltage data corresponding to specific charging cycle information of the target voltage data among the first reference voltage data to the m-th reference voltage data with at least a portion of the target voltage data.

In the device according to an embodiment disclosed in this document, the first reference voltage data to the m-th reference voltage data may be voltage data for a first battery to an m-th battery mounted on a first reference moving object to an m-th reference moving object of the same type as a target moving object on which the battery is mounted.

In the device according to an embodiment disclosed in this document, the one or more processors may be configured to output the battery manufacturer estimation information based on specific target voltage data corresponding to a specific state of charge (SOC) within a threshold SOC section among the target voltage data.

In the device according to an embodiment disclosed in this document, the one or more processors may be configured to output the battery manufacturer estimation information based on specific target voltage data satisfying a threshold charging amount condition among the target voltage data.

In the device according to an embodiment disclosed in this document, the one or more processors may be configured to diagnose a state of the battery based on the battery manufacturer estimation information.

In the device according to an embodiment disclosed in this document, the one or more processors may be configured to diagnose a state of health (SOH) of the battery based on the battery manufacturer estimation information.

In the device according to an embodiment disclosed in this document, the one or more processors may be configured to output first battery manufacturer candidate information to n-th battery manufacturer candidate information based on first target voltage data to n-th target voltage data that respectively correspond to a first charging end point in time to an n-th charging end point in time, and output the battery manufacturer estimation information based on the first battery manufacturer candidate information to the n-th battery manufacturer candidate information.

A method according to an embodiment disclosed in this document includes an operation of acquiring target voltage data for a battery and an operation of outputting battery manufacturer estimation information corresponding to the battery based on at least a portion of the target voltage data.

In the method according to an embodiment disclosed in this document, the operation of outputting the battery manufacturer estimation information may include an operation of outputting the battery manufacturer estimation information based on a result of comparing at least a portion of the target voltage data with at least a portion of first reference voltage data to m-th reference voltage data that respectively corresponding to a first battery manufacturer to an m-th battery manufacturer.

In the method according to an embodiment disclosed in this document, the operation of outputting the battery manufacturer estimation information may include an operation of outputting the battery manufacturer estimation information based on a result of comparing at least a portion of specific first reference voltage data to specific m-th reference voltage data corresponding to specific charging cycle information of the target voltage data among the first reference voltage data to the m-th reference voltage data with at least a portion of the target voltage data.

In the method according to an embodiment disclosed in this document, the operation of outputting the battery manufacturer estimation information may include an operation of outputting the battery manufacturer estimation information based on specific target voltage data corresponding to a specific state of charge (SOC) within a threshold SOC section among the target voltage data.

In the method according to an embodiment disclosed in this document, the operation of outputting the battery manufacturer estimation information may include an operation of outputting the battery manufacturer estimation information based on specific target voltage data satisfying a threshold charging amount condition among the target voltage data.

The method according to an embodiment disclosed in this document may further include, after the operation of outputting the battery manufacturer estimation information, an operation of diagnosing a state of the battery based on the battery manufacturer estimation information.

In the method according to an embodiment disclosed in this document, the operation of diagnosing the state of the battery may include an operation of diagnosing a state of health (SOH) of the battery based on the battery manufacturer estimation information.

In the method according to an embodiment disclosed in this document, the operation of outputting the battery manufacturer estimation information may include an operation of outputting first battery manufacturer candidate information to n-th battery manufacturer candidate information based on first target voltage data to n-th target voltage data that respectively correspond to a first charging end point in time to an n-th charging end point in time, and outputting the battery manufacturer estimation information based on the first battery manufacturer candidate information to the n-th battery manufacturer candidate information.

### ADVANTAGEOUS EFFECTS

According to the embodiments disclosed in this document, the battery manufacturer can be estimated based on the voltage data of the battery.

According to the embodiments disclosed in this document, even if the manufacturers of the batteries mounted on automobiles of the same type of vehicle are different for each automobile, the accurate SOH of the batteries mounted on the corresponding automobile can be calculated.

In addition, various effects that are directly or indirectly identified through this document can be provided.

### BRIEF DESCRIPTION OF THE DRAWINGS

FIG. 1 is a block diagram showing a battery pack according to an embodiment disclosed in this document.
FIG. 2 is a block diagram showing a device according to an embodiment disclosed in this document.
FIG. 3 is a diagram showing target voltage data of a battery according to an embodiment disclosed in this document.
FIG. 4 is a diagram showing battery manufacturer estimation information according to an embodiment disclosed in this document.
FIG. 5A and FIG. 5B are diagrams showing battery state diagnosis information according to an embodiment disclosed in this document.
FIG. 6 is a flowchart showing an operation of a device according to an embodiment disclosed in this document.
FIG. 7 is a block diagram showing a hardware configuration of a computing system for performing an operating method of a device according to an embodiment disclosed in this document.

### MODE FOR CARRYING OUT THE INVENTION

Hereinafter, some embodiments described in this document are described with reference to the accompanying drawings. However, this is not intended to limit the present invention to a specific embodiment, but should be understood to include various modifications, equivalents, and/or alternatives of the embodiments of the present invention.

It should be understood that the various embodiments of the present document and the terms used therein are not intended to limit the technical features described in this document to specific embodiments, but rather include various modifications, equivalents, or substitutes of the embodiments.

In connection with the description, similar reference symbols may be used for similar or related components. A singular form of a noun corresponding to an item may include one item or a plurality of items unless the relevant context clearly indicates otherwise.

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof. Terms such as "first", "second", "firstly", "secondly", "A", "B", "(a)" or "(b)" may be used merely to distinguish one component from another component and, unless otherwise stated, do not limit the components in any other respect (e.g., importance or order).

In this document, when a component (e.g., a first component) is referred to as being "connected", "coupled" or "joined" to another component (e.g., a second component), with or without the terms "functionally" or "communicatively", it means that a component can be connected to another component directly (e.g., in a wired manner), wirelessly, or through a third component.

According to an embodiment, the method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or tentatively generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

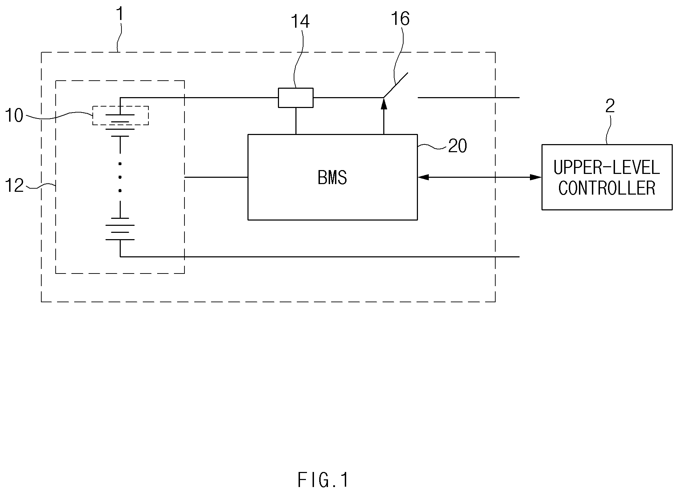

FIG. 1 is a block diagram showing a battery pack according to an embodiment disclosed in this document.

Referring to FIG. 1, a battery pack 1 may include an upper-level battery unit 12, a sensor unit 14, a switching unit 16, and a battery management system (BMS) 20. In this case, the battery pack 1 may be equipped with a plurality of upper-level battery units 12, sensor units 14, switching units 16, and battery management systems 20.

According to the embodiment, the upper-level battery unit 12 may supply power to a target device (not shown). To this end, the upper-level battery unit 12 may be electrically connected to the target device. Here, the target device may include an electrical, electronic, or mechanical device that operates by receiving power from the battery pack 1. For example, the target device may be an electric vehicle (EV), but is not limited thereto.

According to the embodiment, the upper-level battery unit 12 may include at least one battery unit 10 that is chargeable and dischargeable. In this case, the battery unit 10 may be a battery cell 10, and the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to the embodiment, a plurality of upper-level battery units 12 may be connected in series or in parallel. For example, the upper-level battery unit 12 may be a battery module, a battery bank, a battery cell, or a set of battery cells (cell-to-pack structure).

According to the embodiment, the sensor unit 14 may acquire information related to the upper-level battery unit 12. According to the embodiment, the sensor unit 14 may acquire values (or information) related to a state of each of the upper-level battery units 12. In an embodiment, the values related to the state may include one or more values for voltage, current, resistance, a state of charge (SOC), a state of health (SOH), or temperature of the battery cell, or a combination thereof.

According to the embodiment, the sensor unit 14 may provide information on each of the plurality of battery units 12 to the battery management system 20.

According to the embodiment, the switching unit 16 may include a device for controlling the current flow for charging or discharging the upper-level battery unit 12. For example, the switching unit 16 may include at least one relay and/or magnetic contactor, etc., depending on the specifications of the battery pack 1.

According to the embodiment, the battery management system (BMS) 20 may control or manage the battery pack 1 to prevent overcharge and overdischarge, etc. by monitoring the voltage, current, temperature, etc. of the battery pack 1. For example, the battery management system 20 is an interface that receives values obtained by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of upper-level battery units 12 to monitor the state of each of the plurality of upper-level battery units 12 and control ON/OFF of a relay or contactor, etc.

According to the embodiment, an operation of the battery management system 20 may be performed by a battery management system (BMS) in a vehicle, and may also be performed in various devices such as a server, a cloud, a charger, or a charger/discharger.

The upper-level controller 2 may transmit a control signal for the plurality of upper battery units 12 to the battery management system 20. Accordingly, the operation of the battery management system 20 may be controlled based on a signal applied from an upper-level controller 2.

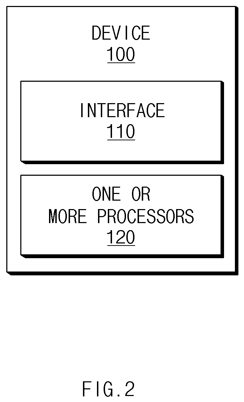

According to the embodiment, the battery management system 20 may include a device 100 of FIG. 2. According to another embodiment, the battery management system 20 may be a different system from the device 100 of FIG. 2. That is, the device 100 of FIG. 2 may be included in the battery pack 1 or may be configured as another device external to the battery pack 1. In the following, for convenience of description, the description will be made on the assumption that the device 100 is composed of another device external to the battery pack 1. In addition, the operation of the device 100 described below may be performed by a BMS in the vehicle, and may also be performed by various devices such as a server, a cloud, a charger, or a charger/discharger. In addition, the battery to be described below may be each of the upper-level battery units 12 or each of the battery cells 10, but is not limited thereto, and may be the battery pack 1.

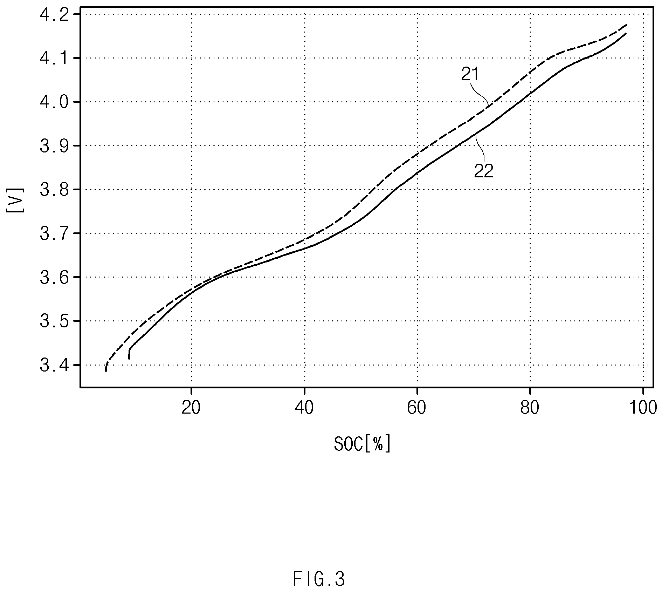

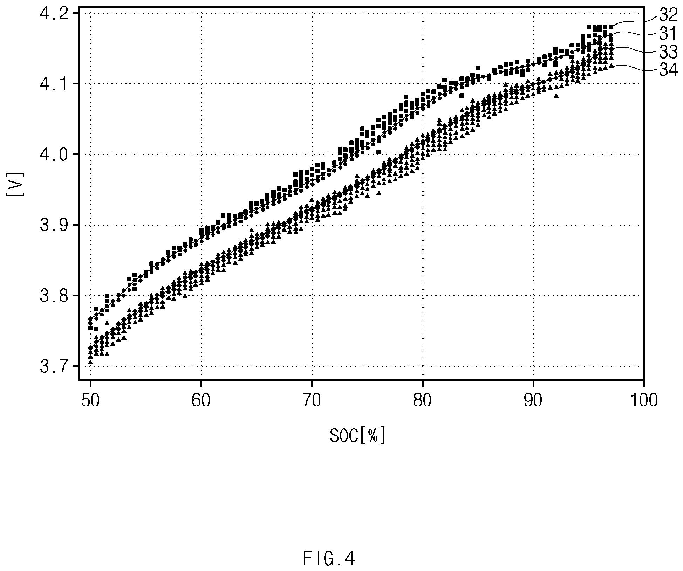

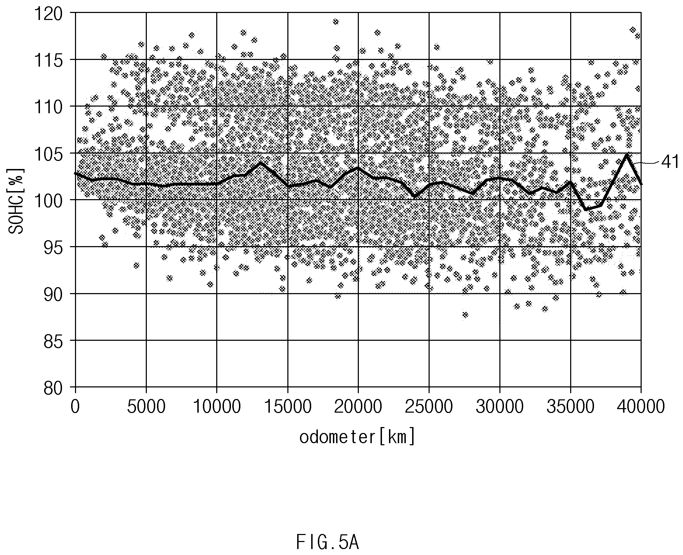

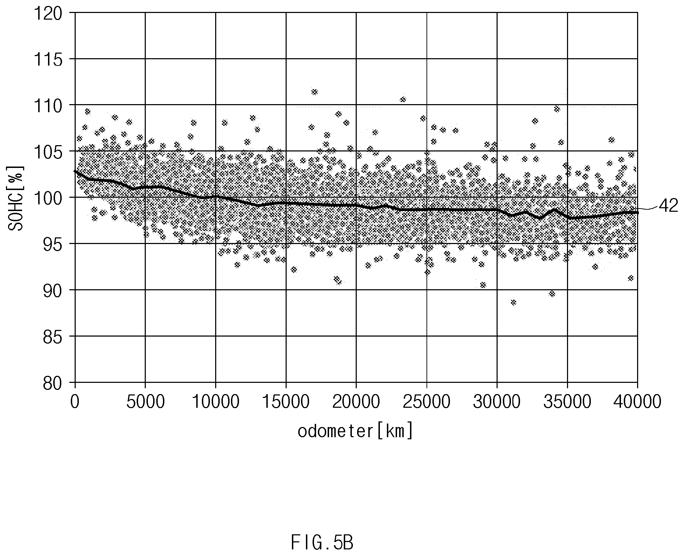

FIG. 2 is a block diagram showing a device according to an embodiment disclosed in this document. FIG. 3 is a diagram showing target voltage data of a battery according to an embodiment disclosed in this document by battery manufacturer. FIG. 4 is a diagram showing battery manufacturer estimation information according to an embodiment disclosed in this document compared to actual battery manufacturer information. FIG. 5A and FIG. 5B are diagrams showing battery state diagnosis information according to a conventional technology and battery state diagnosis information according to an embodiment disclosed in this document. The operation of the device 100 illustrated in FIG. 2 may be described in detail with reference to FIG. 3 to FIG. 5B below.

First, referring to FIG. 2, the device 100 according to an embodiment disclosed in this document may output manufacturer estimation information of a battery.

According to the embodiment, the device 100 may include an interface 110 and one or more processors 120 to output manufacturer estimation information of a battery. However, it is not limited thereto, and other components may be further included in the device 100, two or more components may be integrated into one, or one component may be divided into two or more components.

According to the embodiment, the interface 110 may acquire state information about the battery. Here, the interface 110 may mean a configuration capable of communicating with an external device through wired and/or wireless communication. For example, the state information may include voltage information, current information, temperature information, or resistance information of the battery.

According to the embodiment, the interface 110 may acquire target voltage data by communicating with the sensor unit 14 (see FIG. 1). In addition, the interface 110 may acquire target voltage data by communicating with the BMS 20 (see FIG. 1) or other infrastructure such as a server and a cloud.

According to the embodiment, the interface 110 may acquire target voltage data of the battery. For example, the interface 110 may acquire voltage data for a specific battery mounted on a specific automobile among a plurality of automobiles of a specific vehicle type as target voltage data. For example, the interface 110 may acquire target voltage data of the battery for each unit of time. As another example, the interface 110 may acquire target voltage data of the battery for each unit of driving distance. According to the embodiment, the interface 110 may continuously acquire target voltage data in a charging section, a rest section after charging, a discharging section, and/or a rest section after discharging of the battery according to time and/or driving distance. According to the embodiment, the interface 110 may include a voltage monitoring circuit or sensor.

According to the embodiment, one or more processors 120 may perform operations of the device 100. According to the embodiment, one or more processors 120 may output manufacturer estimation information of the battery based on at least a portion of the target voltage data acquired from the interface 110.

According to the embodiment, the target voltage data may be voltage data corresponding to an SOC at a charging end point in time. According to another embodiment, the target voltage data may be voltage data from a charging start point in time to a charging end point in time. For example, when a specific battery mounted on a specific automobile is charged to SOC 80%, the target voltage data may be data obtained by measuring the voltage of the specific battery at a point in time when the SOC of the specific battery becomes 80%. For reference, since the voltage of the battery drops rapidly during the rest time after charging is ended, accurate target voltage data can be acquired only when the charging end point in time is accurately distinguished by checking the current direction.

FIG. 3 is a diagram showing target voltage data of a battery according to an embodiment disclosed in this document.

Referring to FIG. 3, it is possible to check first target voltage data 21 for a first target battery of a first battery manufacturer mounted on a vehicle of a specific vehicle type (a first vehicle) and second target voltage data 22 for a second target battery of a second battery manufacturer mounted on a vehicle (second vehicle) of a specific vehicle type. For reference, the target voltage data illustrated in FIG. 3 may be voltage data corresponding to the SOC at each charging end point in time. For example, in the case of the first target battery, it may be confirmed that target voltage data corresponding to the SOC (e.g., 60%) at a first charging end point in time is 3.88 V, and target voltage data corresponding to the SOC (e.g., 80%) at a second charging end point in time is 4.07 V. However, as described above, the target voltage data may be voltage data from the charging start point in time to the charging end point in time. For example, in the case of the first target battery, voltage data corresponding to each SOC from voltage data (e.g., 3.38 V) corresponding to SOC (e.g., 5%) at the charging start point in time to voltage data (e.g., 4.18 V) corresponding to SOC (e.g., 95%) at the charging end point in time may be included in the target voltage data.

According to the embodiment, one or more processors 120 may output battery manufacturer estimation information based on specific target voltage data corresponding to a specific SOC within a threshold state of charge (SOC) section among the target voltage data. For example, when a threshold SOC section is a section of SOC 50% to 90%, one or more processors 120 may output battery manufacturer estimation information based on specific target voltage data corresponding to SOC 75% among target voltage data each corresponding to SOC 30%, 45%, and 75%.

According to the embodiment, one or more processors 120 may output battery manufacturer estimation information based on specific target voltage data satisfying a threshold charging amount condition among target voltage data. For example, when the SOC at a charging end point in time is set to be 10% or more greater than the SOC at a charging start point in time as the threshold charging amount condition, one or more processors 120 may output battery manufacturer estimation information based on specific target voltage data corresponding to 20% of a charging amount among target voltage data respectively corresponding to 5%, 9%, and 20% of the charging amount.

For reference, the threshold SOC section may be set based on a vehicle type, battery type, battery capacity, and/or charging method. For example, at least a portion of the SOC section where a battery voltage difference between manufacturers is 40 mV or more during slow charging and a battery voltage difference between manufacturers is 20 mV or more at the charging end point in time may be set as the threshold SOC section.

Referring again to FIG. 3, it may be confirmed that the voltage difference by battery manufacturers in a section where the SOC is greater than or equal to 50% is relatively larger than the voltage difference by battery manufacturers in a section where the SOC is less than 50%. Therefore, when the SOC section where the voltage difference is relatively large is set as the threshold SOC section, the accuracy of distinguishing between the battery manufacturers may be increased.

According to the embodiment, one or more processors 120 may output battery manufacturer estimation information based on a result of comparing at least some of the target voltage data with at least some of a first reference voltage data to an m-th reference voltage data that respectively correspond to a first battery manufacturer to an m-th battery manufacturer. For example, one or more processors 120 may output battery manufacturer estimation information based on a result of comparing specific target voltage data (e.g., target voltage data whose SOC is 80% at the charging end point in time) corresponding to a specific SOC within a threshold SOC section (e.g., a SOC section where SOC is 55% to 85%) among the target voltage data with at least some of the first reference voltage data to the fourth reference voltage data that respectively correspond to the first battery manufacturer to fourth battery manufacturer. As another example, one or more processors 120 may output battery manufacturer estimation information based on a result of comparing specific target voltage data (e.g., target voltage data whose SOC at the charging end point in time is 20% greater than the SOC at the charging start point in time) that satisfies a threshold charging amount condition (e.g., when the SOC at the charging end point in time is 15% greater than the SOC at the charging start point in time) among target voltage data with at least some of first reference voltage data to third reference voltage data that respectively correspond to the first battery manufacturer to the third battery manufacturer. As another example, one or more processors 120 may output battery manufacturer estimation information based on a result of comparing specific target voltage data among target voltage data, whose SOC at the charging end point in time is within the threshold SOC section and which satisfies the threshold charging amount condition, with at least a portion of first reference voltage data to fifth reference voltage data that respectively correspond to a first battery manufacturer to a fifth battery manufacturer.

According to the embodiment, the first reference voltage data to the m-th reference voltage data may be voltage data for a first battery to an m-th battery battery mounted on the first reference vehicle to the m-th reference vehicle of the same type as a target moving object on which the battery is mounted. For example, the first reference voltage data to the m-th reference voltage data may be voltage data measured and acquired in advance for the first battery to the m-th battery that respectively mounted on the first vehicle to the m-th vehicle of the same type as the target automobile on which the target battery whose battery manufacturer is to be estimated is mounted.

For reference, the target battery and the first battery to the m-th battery may have the same or similar design capacity, and the battery manufacturers of each of the first battery to the m-th battery may be different. For example, the first reference voltage data to the m-th reference voltage data may correspond to the first battery manufacturer to the m-th battery manufacturer, respectively.

According to the embodiment, one or more processors 120 may compare at least some of the target voltage data with at least some of the first reference voltage data to the m-th reference voltage data based on a k-Nearest Neighbor (kNN) algorithm, and output battery manufacturer estimation information based on the comparison result. For example, when a specific target voltage data at a specific SOC (e.g., 80%) located within a threshold SOC section (e.g., 50% to 95%) among the target voltage data is 4.09 V, there are two first reference voltage data (e.g., (i) the first reference voltage data of 4.08 V at SOC 80% and (ii) the first reference voltage data of 4.07 V at SOC 79%), and there is one second reference voltage data (e.g., the second reference voltage data of 4.01 V at SOC 80%), one or more processors 120 may output the first battery manufacturer as the battery manufacturer estimation information. For reference, the reference distance may be one of various distance measurement methods such as Euclidean Distance and Manhattan Distance. For reference, the kNN algorithm is only an example to help understanding, but is not limited to the above example.

FIG. 4 is a diagram showing battery manufacturer estimation information according to an embodiment disclosed in this document. For reference, reference numeral 31 represents first reference voltage data, and reference numeral 33 represents second reference voltage data. That is, reference numerals 31 and 33 correspond to reference voltage data acquired in advance for the first battery of the first battery manufacturer and the second battery of the second battery manufacturer that are respectively mounted on the first automobile and the second automobile of the same vehicle type as the target automobile on which the target battery, whose battery manufacturer is to be estimated, is mounted. In this case, the first reference voltage data may include label information about the first battery manufacturer, and the second reference voltage data may include label information about the second battery manufacturer. In addition, reference numeral 32 represents battery manufacturer estimation information corresponding to the first target voltage data, and reference numeral 34 represents battery manufacturer estimation information corresponding to the second target voltage data. That is, reference numeral 32 represents the result of estimating the battery manufacturer for the voltage data (i.e., the first target voltage data) of the target battery of the first battery manufacturer mounted on the target automobile, and reference numeral 34 represents the result of estimating the battery manufacturer for the voltage data (i.e., the second target voltage data) of the target battery of the second battery manufacturer mounted on the target automobile.

Referring to FIG. 4, in the case of the first target voltage data, a square indicating the first battery manufacturer is displayed for voltage data existing within a threshold SOC section (e.g., SOC 50% to 95%), and thus it can be confirmed that the first battery manufacturer is accurately output as the battery manufacturer estimation information 32. Similarly, in the case of the second target voltage data, a triangle indicating the second battery manufacturer is displayed for the voltage data existing within a threshold SOC section, and thus it can be confirmed that the second battery manufacturer is accurately output as the battery manufacturer estimation information 34.

According to the embodiment, one or more processors 120 may output battery manufacturer estimation information based on a result of comparing at least a portion of specific first reference voltage data and specific m-th reference voltage data corresponding to specific charging cycle information of target voltage data among the first reference voltage data to the m-th reference voltage data with at least a portion of the target voltage data. For example, in a state where 1_1st reference voltage data to m-th reference voltage data corresponding to a first charging cycle, 1_2nd reference voltage data to m-th reference voltage data corresponding to a second charging cycle, ..., 1_k-th reference voltage data to m-th reference voltage data corresponding to a k-th charging cycle are stored in a memory or a database, one or more processors 120 may specify 1_100-th reference voltage data to m-th 100-th reference voltage among all reference voltage data by referring to specific charging cycle information (e.g., a 100-th charging cycle) of target voltage data, and output battery manufacturer estimation information based on the result of comparing at least a portion of the 1_100-th reference voltage data to the m_100-th reference voltage data with at least a portion of the target voltage data.

According to the embodiment, one or more processors 120 can increase the estimation accuracy by outputting final battery manufacturer estimation information based on the battery manufacturer estimation information that respectively corresponding to a plurality of charging end points in time.

For example, one or more processors 120 may output first battery manufacturer candidate information to n-th battery manufacturer candidate information based on the first target voltage data to the n-th target voltage data that respectively correspond to the first charging end point to the n-th charging end point, and output the battery manufacturer estimation information based on the first battery manufacturer candidate information to the n-th battery manufacturer candidate information. For example, one or more processors 120 may output first battery manufacturer candidate information based on the first target voltage data corresponding to the first charging end point in time, output second battery manufacturer candidate information based on the second target voltage data corresponding to the second charging end point in time, and output battery manufacturer estimation information based on the first battery manufacturer candidate information and the second battery manufacturer candidate information.

According to the embodiment, one or more processors 120 may diagnose a state of the battery based on the battery manufacturer estimation information. For example, one or more processors 120 may diagnose an SOH of the battery based on the battery manufacturer estimation information. For example, when the first battery manufacturer is estimated as a battery manufacturer of a target battery, one or more processors 120 may acquire first OCV table information corresponding to the first battery manufacturer based on the battery manufacturer estimation information, and diagnose the SOH of the target battery based on the first OCV table information.

FIGS. 5A and 5B are diagrams illustrating a comparison between battery state diagnosis information according to the conventional technology and battery state diagnosis information (SOHc; Capacity SOH) according to an embodiment disclosed in this document.

First, referring to FIG. 5A, as a result of diagnosing the battery state regardless of the battery manufacturer according to the conventional technology, it may be confirmed that tendency of the SOHc 41 to decrease is not observed even though the driving distance increases.

On the other hand, referring to FIG. 5B, as a result of estimating the battery manufacturer according to an embodiment disclosed in this document and diagnosing the battery state based on the estimation result according to an embodiment disclosed in this document, it may be confirmed that the tendency of the SOHc 42 to decrease as the driving distance increases is clearly observed.

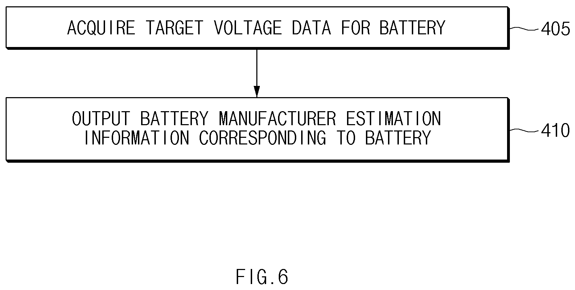

FIG. 6 is a flowchart showing the operation of the device according to an embodiment disclosed in this document.

Referring to FIG. 6, the device 100 may acquire target voltage data for a battery (405), and output battery manufacturer estimation information corresponding to the battery based on at least a portion of the target voltage data (410).

In operation 410, the device 100 may output battery manufacturer estimation information based on the result of comparing at least a portion of the target voltage data with at least a portion of the first reference voltage data to the m-th reference voltage data that respectively correspond to the first battery manufacturer to the m-th battery manufacturer. According to the embodiment, the device 100 may output battery manufacturer estimation information based on the result of comparing at least a portion of specific first reference voltage data to specific m-th reference voltage data corresponding to specific charging cycle information of target voltage data among the first reference voltage data to the m-th reference voltage data with at least a portion of the target voltage data. According to the embodiment, the device 100 may output battery manufacturer estimation information based on specific target voltage data corresponding to a specific SOC within a threshold SOC section, among target voltage data. According to the embodiment, the device 100 may output battery manufacturer estimation information based on specific target voltage data satisfying a threshold charging amount condition among target voltage data. According to the embodiment, the device 100 may output first battery manufacturer candidate information to n-th battery manufacturer candidate information based on each of the first target voltage data to n-th target voltage data that respectively correspond to the first charging end point to the n-th charging end point, and output battery manufacturer estimation information based on first battery manufacturer candidate information or n-th battery manufacturer candidate information.

After operation 410, the device 100 may diagnose the state of the battery based on the battery manufacturer estimation information. According to the embodiment, the device 100 may diagnose a state of health (SOH) of the battery based on the battery manufacturer estimation information.

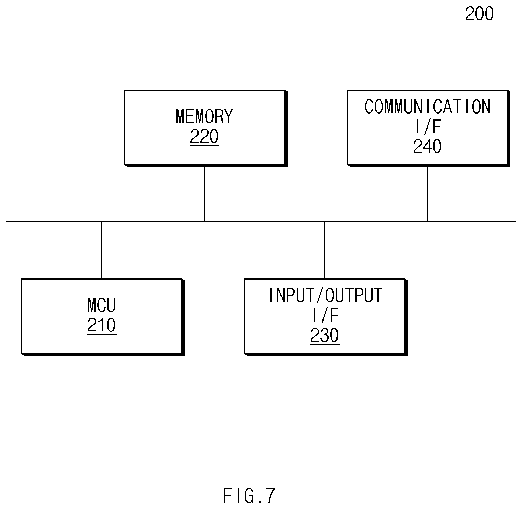

FIG. 7 is a block diagram showing a hardware configuration of a computing system for performing an operating method of the device according to an embodiment disclosed in this document.

Referring to FIG. 7, a computing system 200 according to an embodiment disclosed in this document may include an MCU 210, a memory 220, an input/output I/F 230, and a communication I/F 240.

The MCU 210 may be one or more processors that executes various programs (e.g., battery cell data collection program, graph generation program, data analysis program, data decomposition algorithm, normalization program, and battery cell diagnosis program, etc.) stored in the memory 220, processes various information including battery cell characteristic data, latent variables, etc. through these programs, and performs the functions of the device 100 shown in FIGS. 1 to 6 described above.

The memory 220 may store various programs such as the battery cell data collection program, the graph generation program, the data analysis program, the data decomposition algorithm, the normalization program, and the battery cell diagnosis program.

A plurality of such memories 220 may be provided as needed. The memory 220 may be a volatile memory or a nonvolatile memory. The memory 220 used as the volatile memory may be RAM, DRAM, SRAM, etc. The memory 220 used as the nonvolatile memory may be ROM, PROM, EAROM, EPROM, EEPROM, flash memory, etc. The examples of the memories 220 listed above are only examples and are not limited to these examples.

The input/output I/F 230 may provide an interface that allows data to be transmitted and received by connecting an input device (not shown) such as a keyboard, mouse, or touch panel and an output device (not shown) such as a display with the MCU 210.

The communication I/F 240 is a configuration that can transmit and receive various data with the server, and may be various devices that can support wired or wireless communication. For example, the device 100 may transmit and receive various information including battery state data, etc. to and from a separately provided external server through the communication I/F 240.

In this way, the computer program according to an embodiment disclosed in this document may be implemented as a module that performs, for example, each function shown in FIG. 2, by being recorded in the memory 220 and processed by the MCU 210.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

### [Description of Symbols]

1: Battery pack
2: Upper-level controller
10: Battery unit
12: Upper-level battery unit
14: Sensor unit
16: Switching unit
20: BMS
100: Device
110: Interface
120: At least one processor
200: Computing system
210: MCU
220: Memory
230: Input/output I/F
240: Communication I/F

## Claims

1. A device comprising:
an interface configured to acquire target voltage data for a battery; and
one or more processors configured to output battery manufacturer estimation information corresponding to the battery based on at least a portion of the target voltage data.

2. The device of claim 1, wherein the one or more processors are configured to output the battery manufacturer estimation information based on a result of comparing at least a portion of the target voltage data with at least a portion of first reference voltage data to m-th reference voltage data that respectively corresponding to a first battery manufacturer to an m-th battery manufacturer.

3. The device of claim 2, wherein the one or more processors are configured to output the battery manufacturer estimation information based on a result of comparing at least a portion of specific first reference voltage data to specific m-th reference voltage data corresponding to specific charging cycle information of the target voltage data among the first reference voltage data to the m-th reference voltage data with at least a portion of the target voltage data.

4. The device of claim 2, wherein the first reference voltage data to the m-th reference voltage data are voltage data for a first battery to an m-th battery mounted on a first reference moving object to an m-th reference moving object of the same type as a target vehicle moving object on which the battery is mounted.

5. The device of claim 1, wherein the one or more processors are configured to output the battery manufacturer estimation information based on specific target voltage data corresponding to a specific state of charge (SOC) within a threshold SOC section among the target voltage data.

6. The device of claim 1, wherein the one or more processors are configured to output the battery manufacturer estimation information based on specific target voltage data satisfying a threshold charging amount condition among the target voltage data.

7. The device of claim 1, wherein the one or more processors are configured to diagnose a state of the battery based on the battery manufacturer estimation information.

8. The device of claim 7, wherein the one or more processors are configured to diagnose a state of health (SOH) of the battery based on the battery manufacturer estimation information.

9. The device of claim 1, wherein the one or more processors are configured to:
output first battery manufacturer candidate information to n-th battery manufacturer candidate information based on first target voltage data to n-th target voltage data that respectively correspond to a first charging end point in time to an n-th charging end point in time; and
output the battery manufacturer estimation information based on the first battery manufacturer candidate information to the n-th battery manufacturer candidate information.

10. A method comprising:
an operation of acquiring target voltage data for a battery; and
an operation of outputting battery manufacturer estimation information corresponding to the battery based on at least a portion of the target voltage data.

11. The method of claim 10, wherein the operation of outputting battery manufacturer estimation information includes an operation of outputting the battery manufacturer estimation information based on a result of comparing at least a portion of the target voltage data with at least a portion of first reference voltage data to m-th reference voltage data that respectively corresponding to a first battery manufacturer to an m-th battery manufacturer.

12. The method of claim 11, wherein the operation of outputting battery manufacturer estimation information includes an operation of outputting the battery manufacturer estimation information based on a result of comparing at least a portion of specific first reference voltage data to specific m-th reference voltage data corresponding to specific charging cycle information of the target voltage data among the first reference voltage data to the m-th reference voltage data with at least a portion of the target voltage data.

13. The method of claim 10, wherein the operation of outputting battery manufacturer estimation information includes an operation of outputting the battery manufacturer estimation information based on specific target voltage data corresponding to a specific state of charge (SOC) within a threshold SOC section among the target voltage data.

14. The method of claim 10, wherein the operation of outputting battery manufacturer estimation information includes an operation of outputting the battery manufacturer estimation information based on specific target voltage data satisfying a threshold charging amount condition among the target voltage data.

15. The method of claim 10, further comprising:
after the operation of outputting the battery manufacturer estimation information, an operation of diagnosing a state of the battery based on the battery manufacturer estimation information.

16. The method of claim 15, wherein the operation of diagnosing the state of the battery includes an operation of diagnosing a state of health (SOH) of the battery based on the battery manufacturer estimation information.

17. The method of claim 10, wherein the operation of outputting battery manufacturer estimation information includes an operation of outputting first battery manufacturer candidate information to n-th battery manufacturer candidate information based on first target voltage data to n-th target voltage data that respectively correspond to a first charging end point in time to an n-th charging end point in time and outputting the battery manufacturer estimation information based on the first battery manufacturer candidate information to the n-th battery manufacturer candidate information.
